# EUROPÄISCHE PATENTSCHRIFT

(11) **EP 2 394 288 B1**
(45) Veröffentlichungstag und Bekanntmachung des Hinweises auf die Patenterteilung: **11.10.2017**
(21) Anmeldenummer: 09799555.9
(22) Anmeldetag: 30.12.2009
(51) Int. Cl.: H01J 37/32, H01J 37/34

(54) **MODIFIZIERBARE MAGNETKONFIGURATION FÜR ARC-VERDAMPUNGSQUELLEN**
MODIFIABLE MAGNET CONFIGURATION FOR ARC VAPORIZATION SOURCES
CONFIGURATION D'AIMANT MODIFIABLE POUR SOURCES DE VAPORISATION À ARC

(30) Priorität: 09.02.2009 DE 102009008161
(43) Veröffentlichungstag der Anmeldung: 14.12.2011
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); HAGMANN, Juerg, CH-9468 Sax (CH); GSTOEHL, Oliver, FL-9496 Balzers (LI)
(74) Vertreter: Kempkens, Anke
(86) Internationale Anmeldenummer: PCT/EP2009/009319
(87) Internationale Veröffentlichungsnummer: WO 2010/088947

(56) Entgegenhaltungen:
- EP-A1- 1 970 464
- EP-A2- 0 459 137
- WO-A2-2004/057642
- WO-A2-2007/131944
- DE-A1- 4 017 111
- DE-A1- 10 127 012
- DE-A1- 10 127 013

## Beschreibung

Die vorliegende Erfindung bezieht sich auf eine Verdampfungsquelle, wobei ein Magnetsystem für die Arc-Verdampfungsquelle in Beschichtungsprozessen mit stark reaktiven Gasen, schwach reaktiven Gasen und ohne reaktive Gase verwendet werden kann.

Die vorliegende Erfindung bezieht sich ausserdem auf ein Magnetsystem für eine Arc-Verdampferquelle welches die Verdampfungsrate über die gesamte Target-Lebenszeit konstant hält und auch die optimale Einstellung von Rate und Droplet Emission zulässt.

Eine typische PVD Beschichtungsanlage die mit Funkenverdampfung betrieben wird umfasst eine Vakuumkammer die mit einem Pumpstand verbunden ist, der in der Anlage das prozessbedingte Vakuum erzeugt. Substrathalterungen in der Vakuumkammer dienen dazu, die Substrate (Werkzeuge oder Bauteile oder andere Komponenten) aufzunehmen und diese während der Vorbehandlung und der Beschichtung zu haltern. Die Substrathalterungen und damit die Substrate selbst, können während der Behandlung und insbesondere während der Beschichtung mittels einer Substratbiasversorgung auf eine Spannung gelegt werden, damit diese entweder lonenbeschuss (negative Spannung) oder Elektronenbeschuss (positive Spannung) ausgesetzt werden. Die Substratbiasversorgung kann eine DC-, eine AC- oder eine bi- bzw. unipolare Substratspannungsversorgung sein.

Die Beschichtung erfolgt mittels Funkenquellen. Diese Funkenquellen umfassen ein Target, dessen Material durch den Funken verdampft wird. Ein durch die magnetische Mittel hervorgerufene Quellenmagnetfeld bestimmt, ob ein Funken auf einer bestimmten Bahn geführt wird (sog. "steered arc"), um beispielsweise Spritzer zu reduzieren, oder ob der Funken sich mehr oder weniger frei auf der Targetoberfläche bewegen kann (sog. "random arc"), was meist eine besserer Targetausnutzung und eine höherer Verdampfungsrate zur Folge hat.

D.h. es werden Magnetsysteme zur Bewegung des Funkens auf dem Target eingesetzt. Das sogenannte ARC -Steering mittels speziell gerichteter Magnetfelder erlaubt es, sowohl die Geschwindigkeit des Funkens zu beeinflussen als auch die Funkenbahn auf der Targetoberfläche zu definieren um eine möglichst gute Volumenausnutzung des Targets zu erreichen.

Verschiedene Typen von ARC - spots und deren Bewegungen werden unterschieden, wie sie beispielsweise im Kapitel 3 des durch Raymond L Boxman et al. editierten Handbuchs mit dem englischen Titel "Handbook of Vacuum Arc Science and Technology" vom 1996 angegeben werden. Prinzipiell kann je nach Reaktivität des Gases folgende Beobachtung gemacht werden.

### a) Arc -Verdampfung im Vakuum oder mit Inertgas wie z.B. Argon

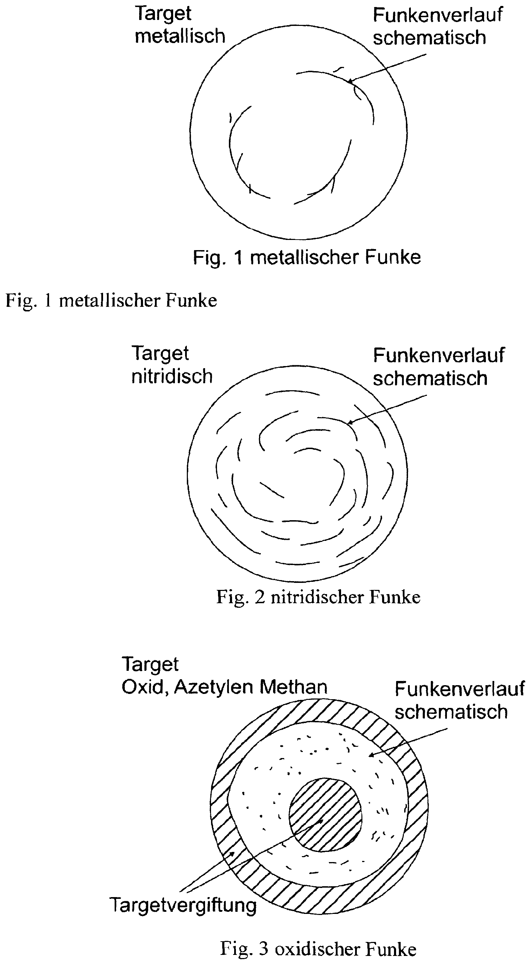

Der Funke läuft relativ langsam auf den durch das Magnetfeld vorgegebenen Bahnen welche bei runden Targets vorwiegend kreisförmig sind. Der Anteil an Random-Bewegung ist eher gering. Die Verdampfungsraten sind in diesem Falle relativ hoch. Die Verdampfung findet unter Emission von relativ grossen Droplets statt. Die Geschwindigkeit des Funkens und sein "Bahndurchmesser" auf dem Target sind über das Magnetfeld einstellbar. Bei einem solchen Verfahren spricht man von einem metallischen Funken. Die Figur 1 zeigt beispielhaft eine entsprechende Bahn.

### b) Arc-Verdampfung in schwach reaktiven Gasen wie z.B. Stickstoff.

Stickstoff reagiert an der Targetoberfläche und bildet eine Nitridschicht von einigen Atomlagen. Es ist dabei eine Erhöhung der Funkengeschwindigkeit festzustellen.

Eine weitere Erhöhung der Funkengeschwindigkeit ist durch stärkere parallel zur Targetoberfläche verlaufende Magnetfelder zu erreichen. Die emittierten Droplets werden dabei vorteilhafterweise kleiner. Es ist im Allgemeinen möglich, homogene Verhältnisse bezüglich der Oberflächenreaktivität d.h. stabile Einstellungen der Verdampfungsrate und der Reaktionsrate des Stickstoffs auf der Targetoberfläche herzustellen.

Aufgrund der relativ hohen Leitfähigkeit der Nitride kann die Funkenerosion auch auf einer nitrierten Oberfläche stattfinden. Daher kommt es auch dort zu einem Netto-Abtrag des Materials, d.h. es bilden sich auf der Targetoberfläche keine dauerhaften beschichteten, zu einer Targetvergiftung führenden Bereiche. Figur 2 zeigt einen dementsprechenden Verlauf.

### c.) Arc-Verdampfung in stark reaktiven Gasen wie z.B. Sauerstoff oder Azetylen, Methan

Dabei komm es zu einer starken Reaktion des Reaktivgases mit der Targetoberfläche. Im Normalfall führt dies bei z.B. Verwendung von Sauerstoff zu elektrisch isolierenden Schichten. Um stabile Verhältnisse zu erhalten ist es wichtig, dass auf der gesamten Targetoberfläche eine Netto-Verdampfung aufrechterhalten werden kann. Gebiete mit geringer lokaler Verdampfungsrate werden isolierend und damit noch weiter von der Verdampfung ausgeschlossen. Die Targetoberfläche wird dabei "vergiftet", wobei dieser Vorgang generell progressiv ist und am Ende nur noch ein kleiner Flächenanteil auf dem Target die Funkenentladung trägt. Speziell bei Verwendung von hohen magnetischen Feldstärken mit grosser radialer Komponente zur Erhöhung der Funkengeschwindigkeit und damit der Verringerung der Dropletgrösse kommt es zu einer starken Inhomogenität der lokalen Verdampfungsrate und damit zu einer schnelleren Vergiftung weiterer Bereiche des Targets.

Wie Ramm J. et.al. in der US Patentanmeldung mit Veröffentlichungsnummer US 2008/0020138 A1 erwähnen, ist zum Beispiel eine stabile Verdampfung von AlCr-Oxid nur möglich wenn das Magnetfeld kleiner als eine maximale Feldstärke ist oder überhaupt kein Magnetfeld verwendet wird. Bei Verwendung von starken Magnetfeldern ist naturgemäss die Magnetfeldverteilung parallel zur Targetoberfläche sehr inhomogen und es entstehen daher rasch Bereiche an der Targetoberfläche welche eine isolierende Schicht haben. Der entsprechende Funkenverlauf ist in Figur 3 schematisch dargestellt.

Wie oben diskutiert lassen sich also mit ein und demselben metallischen Target unterschiedliche Schichten erzeugen, indem beispielsweise mit inerten Gasen, schwach reaktiven Gasen oder stark reaktiven Gasen beschichtet wird. Die inerten Gase gehen mit dem Targetmaterial keine Verbindung ein während die reaktiven Gase zu leitenden oder isolierenden Schichten auf der Targetoberfläche führen. Um eine stabilen Beschichtungsprozess zu erhalten ist es vorteilhaft eine auf jeden dieser Fälle angepasste Magnetfeldlinienverteilung auf und oberhalb der Targetoberfläche zu realisieren, die jeweils die Funkenbahn in Verlauf und Geschwindigkeit beeinflusst.

Es gibt unterschiedliche dem Stand der Technik bekannte Möglichkeiten, eine Magnetfeldlinienverteilung auf und oberhalb der Targetoberfläche zu realisieren. Dies ist beispielsweise mit Permanentmagneten und/oder mit Elektromagneten und/oder deren Kombination, wie in der europäischen Patentanmeldung EP 1970464 A1 offenbart, möglich.

Ausserdem ist dem Stand der Technik bekannt Magnetfeldanordnungen gegenüber der Targetoberfläche beweglich anzuordnen so dass aufgrund der damit erzielbaren Bewegbarkeit der Lichtbogenbahnen ein gleichmässiger Abtrag von Targetmaterial erreicht werden kann. Curtins H. offenbart in der deutschen Offenlegungsschrift DE 10127012A1 dementsprechend eine Magnetfeldanordnung die eine Halterung aufweist, von der eine Ringspule sowie ein Permanentmagnet ausgehen. Um mittels der Magnetfeldanordnung, d.h. der von der Ringspule und dem Permanentmagnet erzeugten Magnetfeldern im Bereich des Lichtbogenspots ein wirksames Magnetfeld auf der Oberfläche des Targets so einzustellen, dass der Lichtbogen bzw. -spot in definierten Bahnen die gesamte Oberfläche des Targets überstreichen kann mit der Folge dass ein gleichmässiger Abtrag von Targetmaterial erfolgt, ist die Magnetfeldanordnung als Einheit zu dem Target verstellbar und zwar in einer parallel zur Targetfläche verlaufenden Ebene. Des Weiteren kann die Einheit gegebenenfalls zum Target im gewünschten Umfang beabstandet werden, also einer Verschiebung in Z-Richtung unterworfen werden.

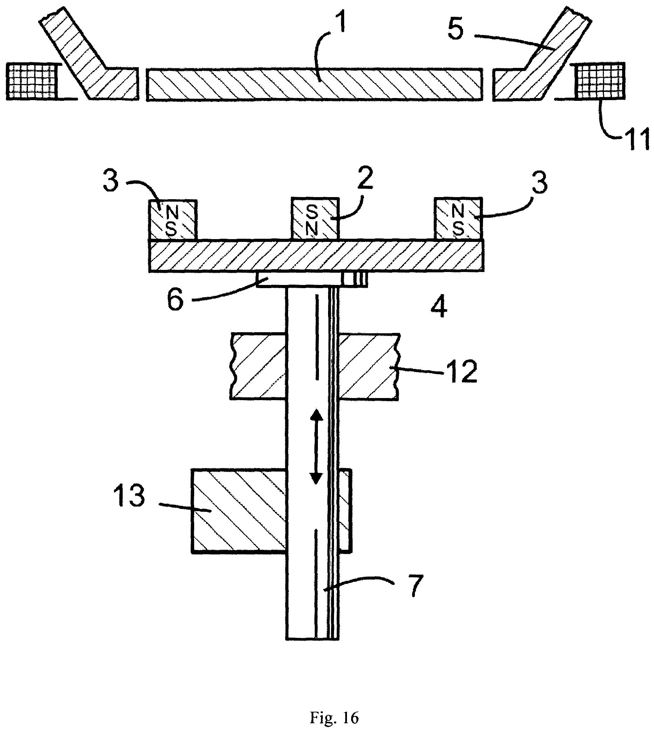

Das europäische Patent EP 0459137 B1 offenbart eine Magnetfeldanordnung mit einem Mittelpol-Permanentmagnet und Rand-Permanentmagnet, die beide gemeinsam axial, d.h. senkrecht zur Targetoberfläche verschiebbar sind. Ausserdem ist im Bereich des Targets eine elektromagnetische Ringspule vorgesehen, die bei der Bogenentladung so angesteuert sein kann, dass sie die sich ausbildende Bogenspur beeinflusst und damit zu einer Erhöhung der Standzeit des Targets beiträgt. In EP 0459137 B1 liegt das Target im Innenraum der Ringspule. Die Targetoberfläche und das Spulenende liegen gemäss der Figur 2 von EP 0459137 B1 im Wesentlichen in einer Ebene (siehe Figur 16 dieser Anmeldung).

Dementsprechend umfasst die Spule das Target und auch Teile der Wand der als Gefäss bezeichneten Vakuumkammer. Hierdurch wird erreicht dass die durch die Spule erzeugten Magnetfelder im Wesentlichen keine radialen Komponenten auf der Oberfläche des Targets haben. Ein solches vertikales Spulenfeld hat somit keinen Einfluss auf die Geschwindigkeit mit der der Spot des Lichtbogens über die Targetoberfläche wandert.

Demgegenüber wäre es vorteilhaft eine Arc-Verdampfungsquelle mit einer Magnetfeldanordnung zu haben, wobei die Magnetfeldanordnung aufgrund des Feldlinienverlaufs am Rand des Targets zu einer höheren Geschwindigkeit und damit zu einer geringeren Verweildauer führt. Dies würde zu einem Target mit integrierten Mitteln zum Erzeugen von Magnetfeldern führen, mit welchem eine Funkenverdampfung sowohl mit stark reaktiven als auch mit schwach reaktiven und auch inerten Gasen effizient möglich ist.

Erfindungsgemäss wird die Aufgabe durch eine Arc-Verdampfungsquelle mit einer Magnetfeldanordnung gemäss dem Anspruch 1 gelöst, welche Rand-Permanentmagneten und mindestens eine Ringspule umfasst, wobei die Rand-Permanentmagneten im Wesentlichen senkrecht zur Oberfläche des Targets vom Target weg verschiebbar sind und die Projektion der Rand-Permanentmagneten auf die Targetoberfläche im Vergleich zur Projektion der Ringspule auf die Targetoberfläche von der Mitte der Targetoberfläche weiter entfernt ist. Dabei ist die Ringspule hinter dem Target angeordnet und hat einen durch die Wicklungen definierten Innendurchmesser der nicht wesentlich grösser und vorzugsweise kleiner oder gleich dem Durchmesser des Targets ist.

Die Erfinder haben festgestellt, dass bei vom Target weggeschobenen Rand-Permanentmagneten und eingeschaltetem Spulenstrom der Beschichtungsprozess wesentlich stabiler läuft als mit einer Spulenanordnung gemäss der Figur 2 der Patentschrift EP 0459137 B1. Dies mag damit zusammenhängen, dass mit einer solchen Anordnung erreicht wird, dass die Feldlinien des durch die stromdurchflossene Spule angeregten Magnetfeldes im zentralen Bereich der Targetoberfläche im Wesentlichen keine radiale Komponente enthalten, während sie im Randbereich der Targetoberfläche radiale Komponenten enthalten.

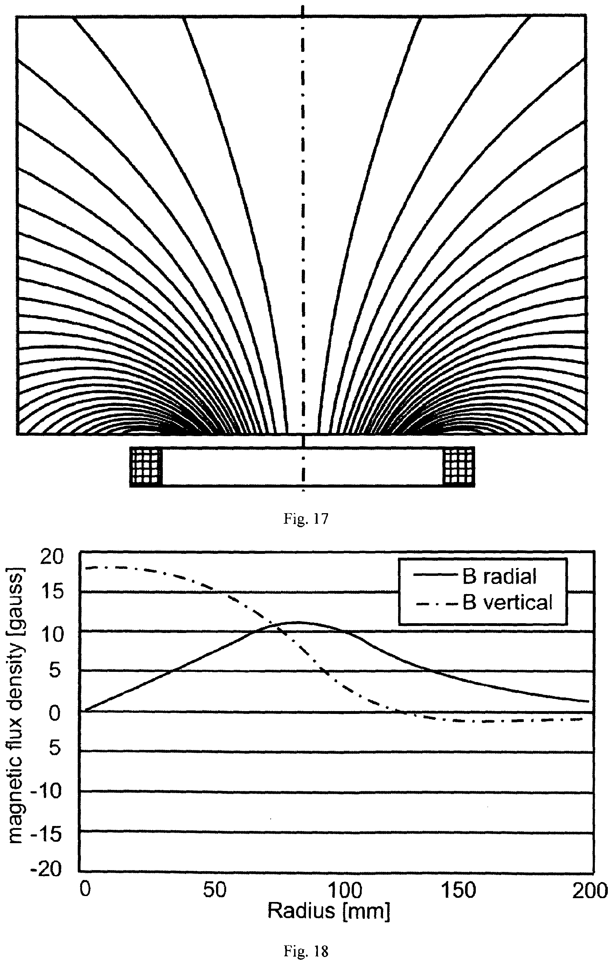

Zur Verdeutlichung wird in Figur 17 das eine Spule erzeugten Magnetfeld (genauer der Verlauf der Magnetfeldlinien) schematisch dargestellt und in Figur 18 die axiale Komponente und die Radiale Komponente als Funktion des Abstandes von der Spulenachse knapp oberhalb des Spulenendes dargestellt

Gemäss einen weiteren Aspekt der vorliegenden Erfindung umfasst die Magnetfeldanordnung zusätzlich einen zentralen Permanentmagneten wobei die Projektion des Inneren der Ringspule auf die Targetoberfläche im Vergleich zur Projektion des zentralen Permanentmagneten auf die Targetoberfläche von der Mitte der Targetoberfläche weiter entfernt ist und der zentrale Permanentmagnet im Wesentlichen senkrecht zur Oberfläche des Targets vom Target weg verschiebbar ist.

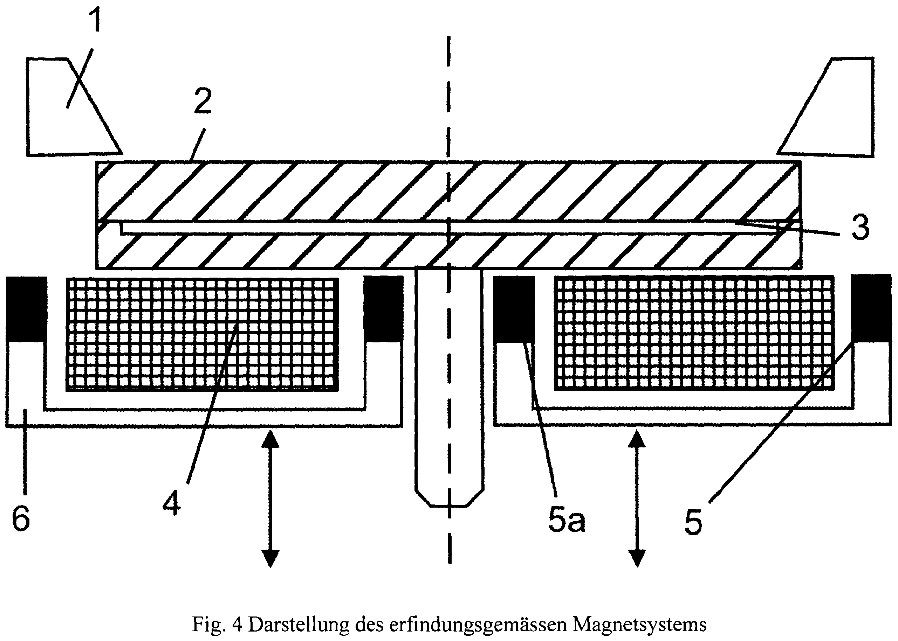

Im Anschluss wird die Erfindung mit Beispielen und anhand der Figuren näher erläutert. Dabei zeigt Figur 4 ein Target mit Magnetsystem gemäss einer ersten Ausführungsform.

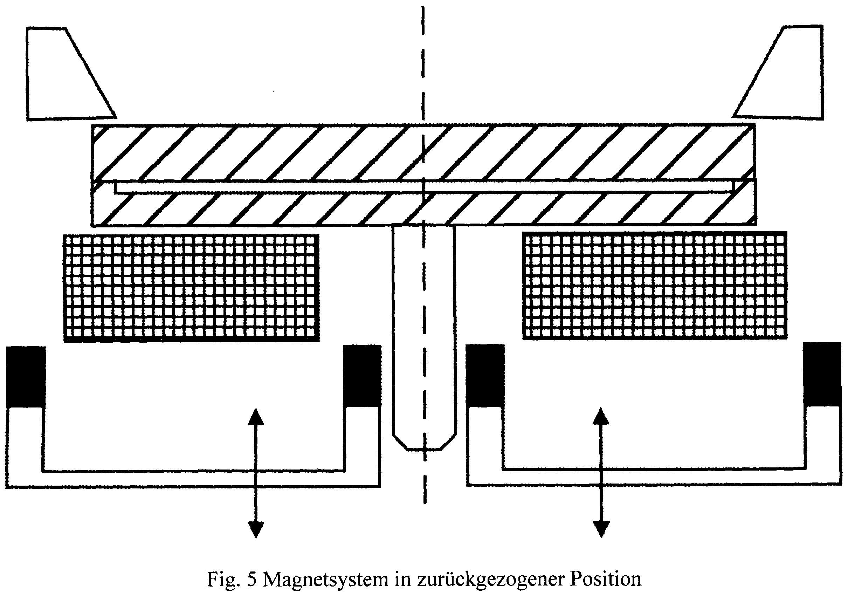

In dieser Ausführungsform wird das Magnetfeld durch eine fix angeordnete Spule 4 und durch ein permanentes Magnetarrangement 5, 5a erzeugt, wie in der Figur 4 gezeigt. Das Magnetarrangement 5, 5a mit einer Magnetaufnahme 6 ist in axialer Richtung, weg vom Target verschiebbar. Diese Verschiebbarkeit ist in der Figur 5 gezeigt.

Für das oben beschriebene Magnetsystem ergeben sich folgende grundsätzliche Einstellungen.

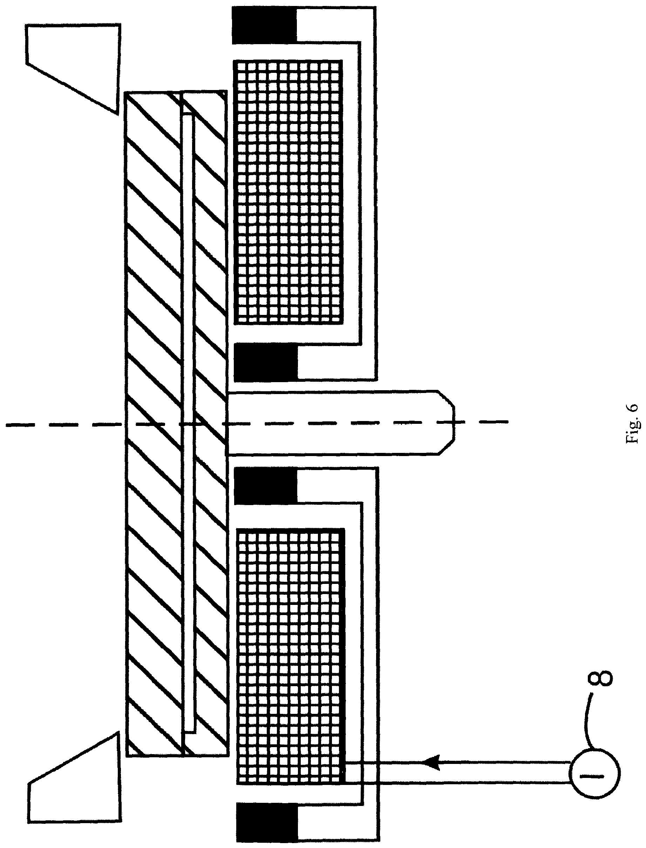

Einstellung 1, wie schematisch in Figur 6 gezeigt:
Der Permanentmagnet (5, 5a, 6) nimmt die Position ein, bei der seine Pole dem Beschichtungsmaterial am nächsten sind (Position "vorne"). Vorzugsweise sind ein Spulenende und Pole bei dieser Einstellung im Wesentlichen in einer Ebene. Der SpulenStrom ist eingeschaltet. Er kann sowohl Positiv als auch Negativ geschaltet sein (8)und er kann auch moduliert werden. Diese Einstellung erzeugt ein starkes Magnetfeld von ca. 60-100 Gauss. Damit ist diese Einstellung beispielsweise für die Verdampfung von Nitridschichten geeignet. Durch die hohe magnetische Feldstärke und deren radialen Anteil wird der Funken schnell bewegt. Dadurch ergeben sich glatte Schichten. Mit dem Magnetfeld der Spule, welches dem Feld der permanenten Magnete überlagert ist, wird der Verlauf der Feldlinien und damit die Bahn des Funkens beeinflusst. Vorzugsweise wird der Spulenstrom zeitlich moduliert und damit eine Verbreiterung des Erosionsgrabens erreicht.

Mit einer solchen Einstellung gelingt die Erzeugung von Hartstoffschichten wie zum Beispiel TiN , TiAlN, AlTiN, AlCrN, TiSiN.

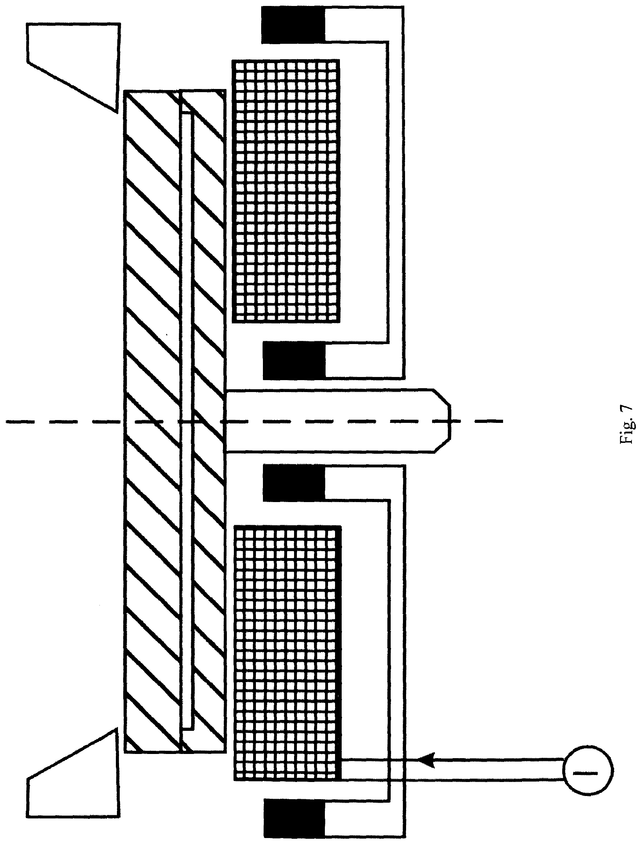

Einstellung 2, wie in Figur 7 gezeigt:
Der Permanentmagnet (5, 5a, 6) ist um 5-50mm "zurückgezogen", d.h. weiter beabstandet von der Targetoberfläche als in Einstellung 1. Der Spulenstrom ist wiederum eingeschaltet und kann positiv oder negativ sein und auch moduliert werden.

Diese Einstellung erzeugt graduell, je nach Verschiebung, ein Magnetfeld von 10 - 40 Gauss inklusive einem überlagerten Spulenfeld. Es kann einerseits mit zunehmender Verschiebung die Verdampfungsrate erhöht werden, wobei dann mit raueren Schichten mit grösseren Droplets gerechnet werden muss. Andererseits kann bei Verwendung von Gasen wie zum Beispiel Sauerstoff und/oder Azetylen durch die Verschiebung des Magnetarrangements (5, 5a, 6) ein Gleichgewicht zwischen Targetvergiftung und Erosionsrate an vielen Punkten der Targetoberfläche hergestellt werden. Hierdurch kann der Beschichtungsprozess erheblich stabilisiert werden.

Diese Einstellung ist sowohl geeignet für die Erzeugung von Nitridschichten bei hoher Beschichtungsrate wie TiN, TiAlN, AlTiN, TiSiN als auch zur Herstellung von Carbonitriden oder Carbiden unter Verwendung von Gasen wie Azetylen oder Methan. Vor allem ist sie aber auch geeignet zur Herstellung von verschiedensten Oxidschichten wie zum Beispiel Al₂O₃, ZrO, TiO₂ oder deren Mischungen entsprechend dem Ausgangsmaterial des Targets.

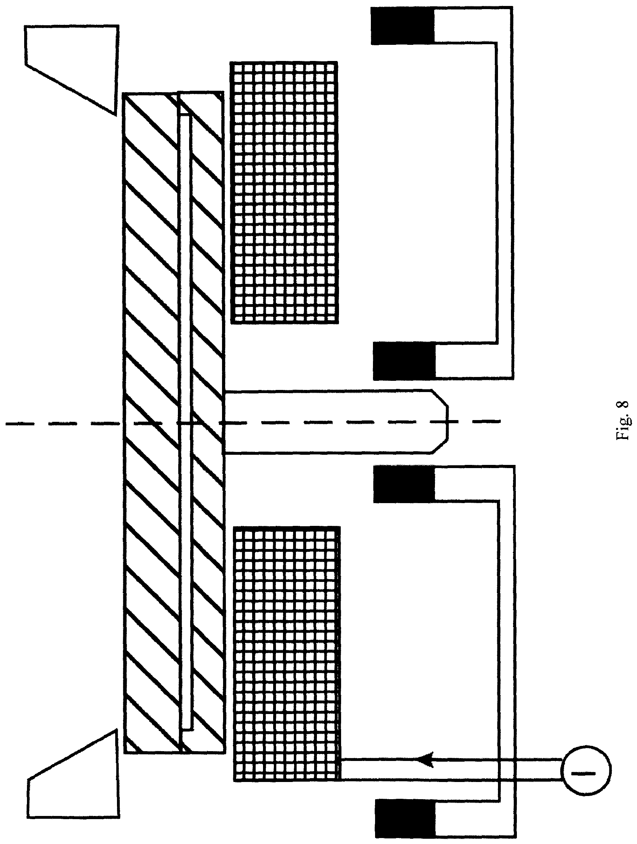

Einstellung 3, wie in Figur 8 gezeigt:
Bei dieser Einstellung ist der Permanentmagnet (5, 5a, 6) um mehr als 50 mm zurückgezogen, d.h. ganz von der Spule separiert. Das Spulenfeld ist wiederum eingeschaltet, positiv oder negativ und/oder wird gegebenenfalls moduliert. Der Magnetfeldanteil des permanenten Magnetarrangements wird aber vernachlässigbar klein. Je nach Stromstärke ist das Spulendfeld ca. 5- 15 Gauss.

Diese Einstellung ist geeignet für die Abscheidung von metallischen Schichten und/oder von Nitrid-, Carbonitrid-, Carbid- und/oder Oxyd-Schichten. Wie bereits weiter oben diskutiert gilt für hochreaktive Gase, dass das magnetische Feld der Spule nicht zu hoch sein soll (maximal ca. 10 Gauss). Damit ein Betrieb des ARC-Verdampfers ohne Vergiftung von Targetbereichen möglich

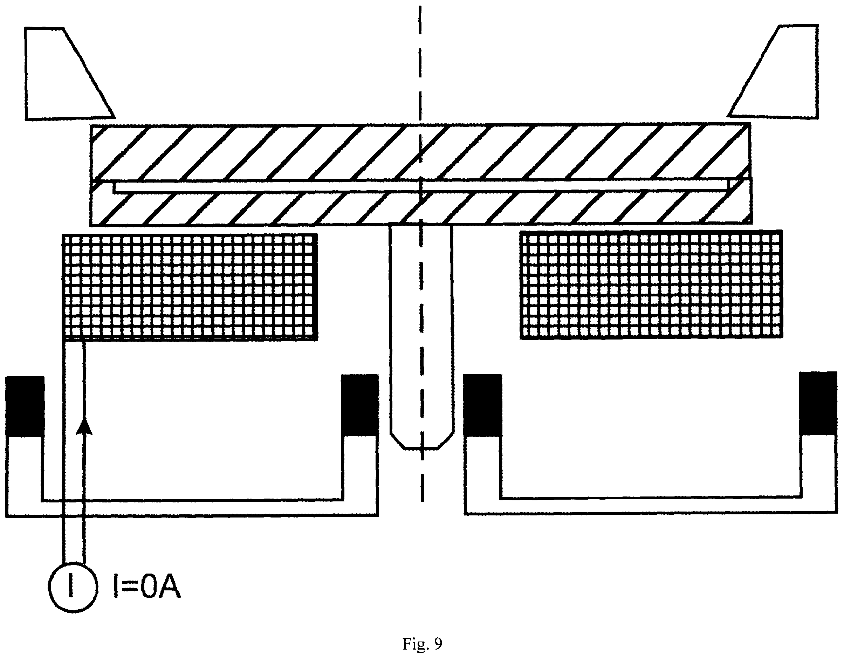

Einstellung 4, wie in Figur 9 gezeigt:
Der Permanentmagnet (5, 5a, 6) ist in dieser Einstellung um mehr als 50mm zurückgezogen und der Spulenstrom ausgeschaltet. In dieser Einstellung wird die ARC-Quelle im sogenannten Random-Modus betrieben und auf der Targetoberfläche sind keine nennenswerten Magnetfelder vorhanden. Dies ist besonders vorteilhaft bei hochreaktiven Gasen wie Sauerstoff. Der Funke der ARC-Entladung läuft dabei mit sehr vielen ARC-Spots in zufälliger Weise über das Target. Die Entladung läuft sehr stabil und es können keine Bereiche mit Targetvergiftung entstehen.

Wird diese Magneteinstellung allerdings metallisch (ohne Reaktiv Gas oder im Hochvakuum) oder nitridisch betrieben, ist eine hohe Verdampfungsrate unter sehr hohem Dropletanteil zu beobachten.

Wie aus den Figuren hervorgeht können alle Quellenposition in einer Vakuumkammer mit demselben Target realisiert werden. D.h. man kann in demselben Beschichtungsprozess durch Veränderung der Magnetposition nach Fig. 6-9 wahlweise zur Erzeugung von metallischen-, nitritischen Schichten, Carbonitriden , Carbiden oder Oxiden das Magnetfeld an die Erfordernisse optimal anpassen. Es müssen keine Quellenpositionen exklusiv für die jeweiligen Schichttypen reserviert werden. Dadurch können Beschichtungsprozesse mit hoher Produktivität realisiert werden.

Auf diese Art und Weise wurde mit ein und demselben AlCr Target (70%:30%) folgendes Schichtsystem mit drei Schritten beschichtet:
1) eine metallische Haftschicht mit der Einstellung 1. Beachtlich ist hierbei dass die Erosion des Targets durch Wobbeln der Spule optimiert wurde.
2) eine AlCrN als erste Hartschicht mit der Einstellung 2
3) eine AlCryOx als zweite Hartschicht mit der Einstellung 3

In einem zweiten Beispiel wurde ein Ti-Target verwendet. Wiederum wurde als erstes eine metallische Haftschicht mit der Einstellung 1 aufgebracht. Zusätzlich wurde durch Wobbeln der Spule die Erosion des Targets optimiert. Als nächstes wurde eine TiCN Schicht mit der Einstellung 2 aufgebracht und anschliessend eine TiN Schicht mit der Einstellung 3.

Gemäss einem weiteren Aspekt der vorliegenden Erfindung wird ein Magnetsystem für eine Arc- Verdampferquelle offenbart, mit welchem die Verdampfungsrate über die gesamte Target Lebenszeit konstant gehalten werden kann. Ausserdem lässt dieses die optimale Einstellung von Rate und Droplet-Emission zu.

Die Verdampfungsrate einer ARC-Quelle wird unter anderem sehr stark durch das Magnetfeld parallel zur Targetoberfläche bestimmt. Ein stärkeres Magnetfeld erhöht die Geschwindigkeit des Funkens und erniedrigt damit die Verdampfungsrate bei gleichzeitiger Abscheidung von glätteren Schichten. Mit zunehmender Targeterosion nähert sich die Targetoberfläche immer mehr dem dahinter liegenden Magnetsystem, dies äussert sich in einer starken Zunahme der magnetischen Feldstärke und einem Abfall der Beschichtungsrate. Das vorliegende erfinderische Magnetsystem kann die Abstandsänderung der Targetoberfläche zum Magnetsystem durch Verschieben des Permanent-Magnetarrangements ausgleichen und damit eine konstante Verdampfungsrate über die gesamten Nutzungsdauer des Targets gewährleisten.

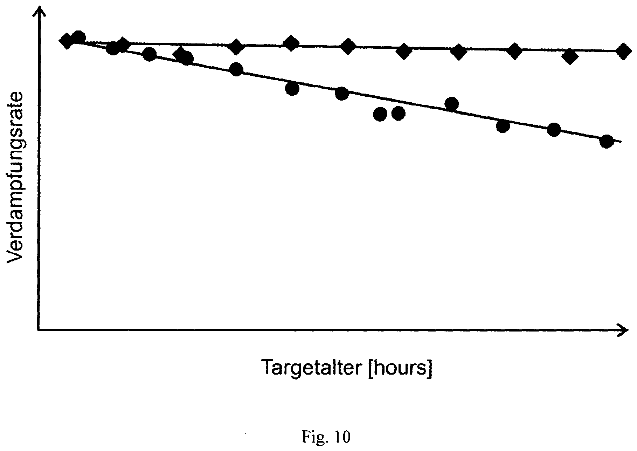

Der Abstand der Targetoberfläche zum Magnetsystem bestimmt im Wesentlichen die Mangetfeldstärke und damit die Rate der Verdampfung. Bei einem neuen, unverbrauchten Target liegt der maximale Abstand und damit die geringste Magnetfeldstärke vor. Eine Erosion während dem Beschichtungsprozess führt zu einer sukzessiven Abnahme des Abstandes der Targetoberfläche zum Magnetsystem, und damit eine Erhöhung der Magnetfeldstärke und Abnahme der Rate. Dies wird anhand von Figur 10, Datenreihe mit Kreisflächensymbolen deutlich.

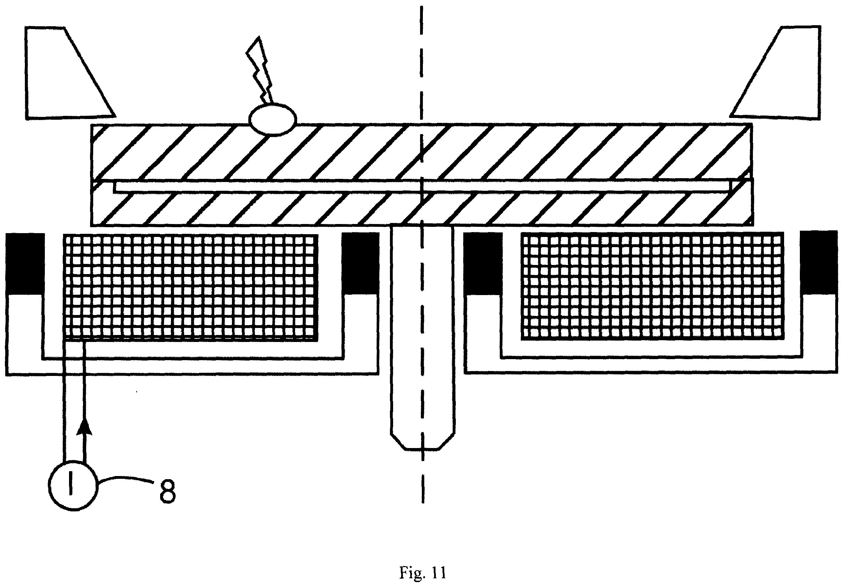

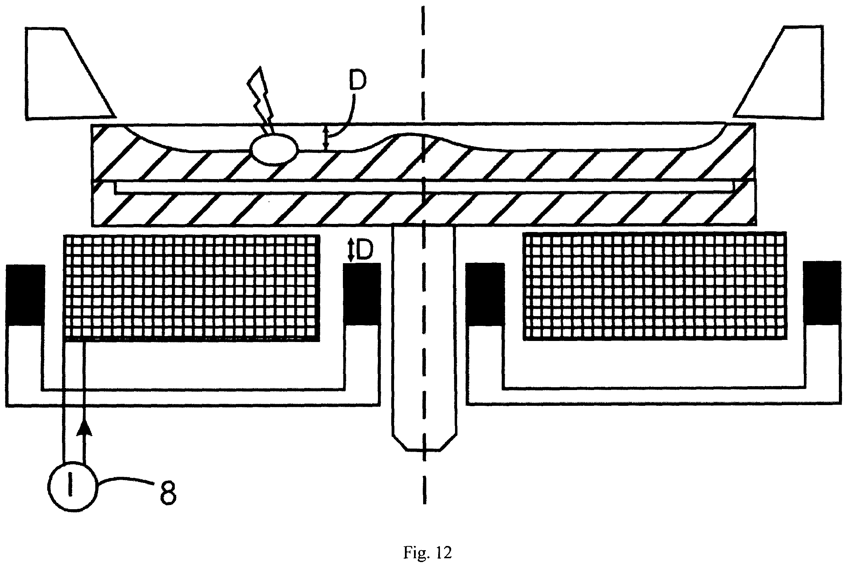

Um den Vorgang wie oben beschrieben zu kompensieren, wird erfindungsgemäss das Magnetsystem entsprechend der Erosionstiefe vom Target zurückgezogen um im Wesentlichen den Ausgangszustand bei neuem Target herzustellen. Damit wird eine im Wesentlichen konstante Rate über den gesamten Nutzungszeitraum des Targets (Targetlife) erreicht. Dies ist in Figur 10, Datenreihe mit Rautensymbolen gezeigt. Figur 12 zeigt im Vergleich mit Figur 11 noch zur Verdeutlichung der Situation die Erosion des Targets um die Dicke D und die dementsprechend nach unten verschobenen permanenten Magnete.

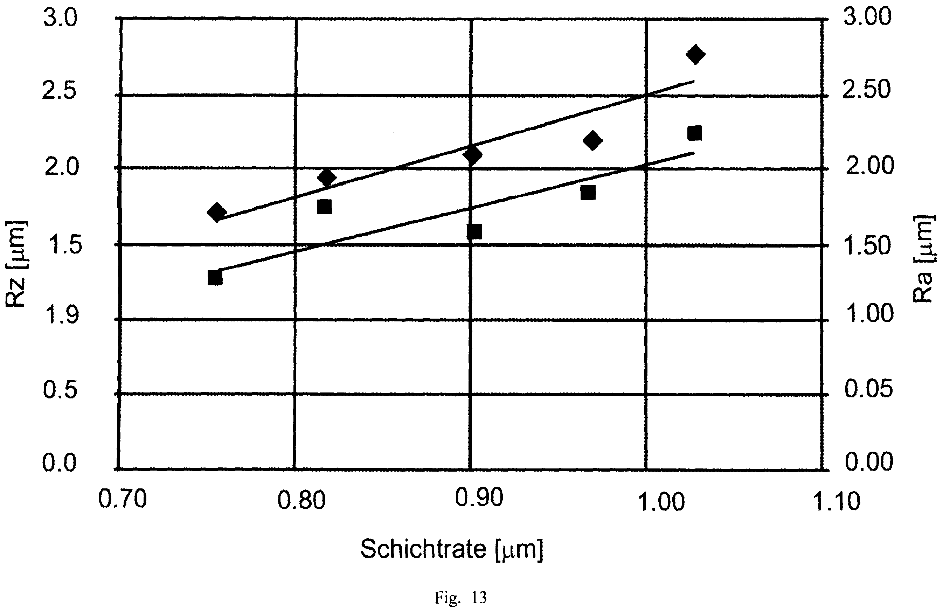

Wie oben bereits erwähnt ist die Emission von Droplets (Macroparticles) bzw. die Grösse der emittierten Droplets unter anderem abhängig von der Geschwindigkeit des durch das Magnetfeld bewegten Funkens (Arc-Steering). Durch die geeignete Einstellung der Permanent-Magnetposition ist die Quelle zwischen hoher Rate und rauer Schicht bzw. tieferer Rate und glatter Schicht einstellbar. Dies wird durch Figur 13 deutlich, die die Abhängigkeit der Schichtrauhigkeit (Rz, Ra) von der über das Magnetsystem eingestellten Beschichtungsrate aufzeigt.

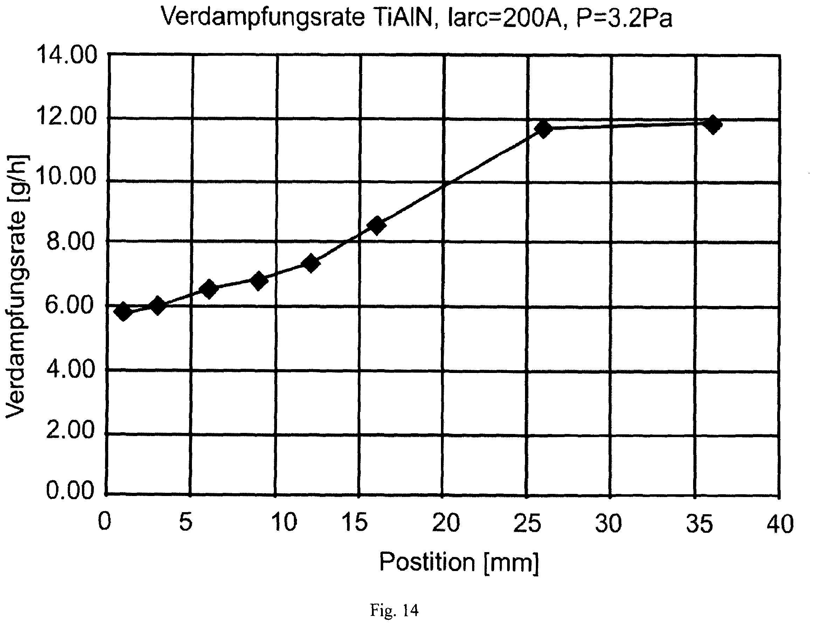

In Figur 14 ist zusätzlich noch dargestellt, wie sich die Beschichtungsrate in Abhängigkeit der Magnetposition verändert und sich damit die Rate einstellen lässt.

Das Nachführen des Permanentmagneten führt also einerseits zu einer Stabilisierung des Beschichtungsprozesses durch konstante Aufdampfrate und konstante Entladungsspannung. Ausserdem ist die Dauer der Beschichtungsprozesse durch die konstante Rate für gleichartige Beschichtungen nahezu gleich, unabhängig vom Targetalter. Mittels des erfindungsgemässen Magnetsystems können aber auch gezielt verschiedene Raten für verschiedene Anforderungen eingestellt werden und es lassen sich Schichteigenschaften, wie z.B. Rauhigkeit und Mikrostruktur gezielt beeinflussen.

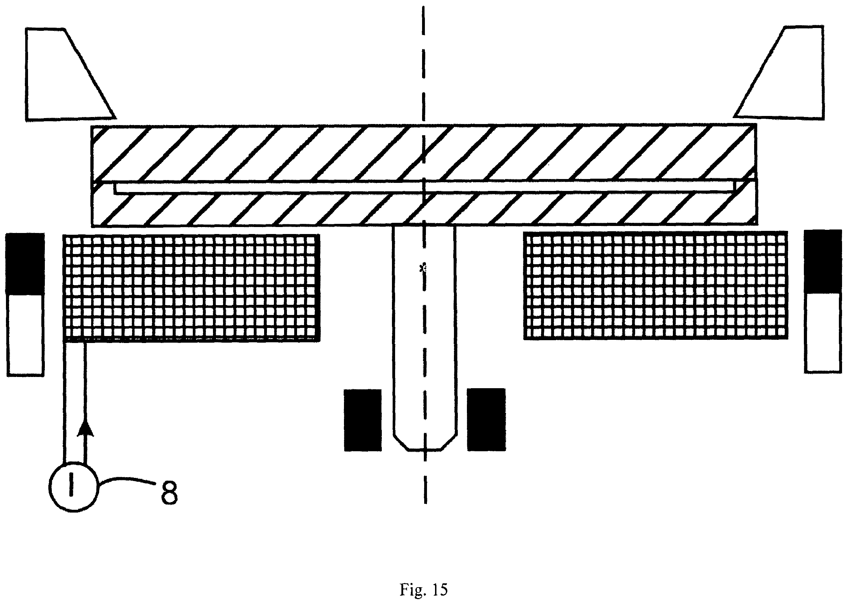

Gemäss einem weiteren Aspekt der vorliegenden Erfindung kann die Schichtdickenverteilung über die Fläche des zu beschichtenden Werkstücks homogen eingestellt werden. Dies wird erzielt mittels des erfindungsgemässen Magnetsystems in einer Ausführungsform derart, dass der innere Permanentmagnet gegenüber dem Target um ca. 50mm unabhängig vom äusseren Permanentmagneten zurückgezogen werden kann. Auch der äussere Permanentmagnet kann vertikal zum Target verschoben werden, bevorzugt um einige Millimeter. Dies ist in Figur 15 gezeigt.

Der Spulenstrom kann positiv als auch negativ angelegt werden, wobei je nach Vorzeichen des Spulenstromes die Aufdampfcharakteristik der ARC-Quelle verändert werden kann. Das heisst es kann die Verteilungscharakteristik eingestellt werden.

## Patentansprüche

1. Arc-Verdampfungsquelle mit einer an einem Target (2) aus einem Beschichtungsmaterial vorgesehenen Magnetfeldanordnung zur Erzeugung von Magnetfeldern an und oberhalb der Targetoberfläche, wobei die Magnetfeldanordnung Zentralpermanentmagneten (5a) Rand-Permanentmagneten (5) und mindestens eine hinter dem Target angeordnete Ringspule (4) umfasst deren durch die Wicklungen begrenzter Innendurchmesser vorzugsweise kleiner oder gleich, jedenfalls nicht wesentlich grosser als der Durchmesser des Targets ist, **dadurch gekennzeichnet, dass** die Rand-Permanentmagneten (5) und die Zentralpermanentmagneten (5a) im Wesentlichen senkrecht zur Oberflache des Targets (2) vom Target (2) weg verschiebbar sind und die Projektion der Rand-Permanentmagneten (5) auf die Targetoberfläche im Vergleich zur Projektion der Ringspule (4) auf die Targetoberfläche von der Mitte der Targetobertläche weiter entfernt ist, wobei die Verschiebbarkeit der Rand-Permanentmagneten (5) und der Zentralpermanentmagneten unabhängig von der Ringspule (4) verwirklicht werden kann, und wobei die Magnetanordnung derart konfiguriert ist, dass bei einer ersten Einstellung der Magnetfeldanordnung, die Zentralpermanentmagneten (5a) und die Rand-Permanentmagneten (5) eine erste Position einnehmen können, bei der die Pole der Permanentmagneten (5, 5a) dem Beschichtungsmaterial am nächsten sind, und wobei sich die Pole der Permanentmagneten (5, 5a) im Wesentlichen in einer Ebene befinden, bei der auch sich ein Ende der Ringspule (4) befindet, welches dem Beschichtungsmaterial am nächsten ist.

2. Arc-Verdampfungsquelle gemäss Anspruch 1, **dadurch gekennzeichnet, dass** die Magnetanordnung derart konfiguriert ist, dass bei einer zweiten Einstellung der Magnetfeldanordnung, die Zentralpermanentmagneten (5a) und die Rand-Permanentmagneten (5) eine zweite Position einnehmen können, bei der die Permanentmagneten (5, 5a) zurückgezogen, weiter beanstandet von der Targetoberfläche sind, und bei der das Ende der Ringspule (4), welches dem Beschichtungsmaterial am nächsten ist, in einer Ebene näher zum Beschichtungsmaterial als die Pole der Permanentmagneten (5, 5a) ist.

3. Arc-Verdampfungsquelle gemäss Anspruch 2, **dadurch gekennzeichnet, dass** die Magnetanordnung derart konfiguriert ist, dass bei der zweiten Einstellung der Magnetfeldanordnung, die Zentralpermanentmagneten (5a) und die Rand-Permanentmagneten (5) einer Position einnehmen können, bei der die Pole der Permanentmagneten (5, 5a) sich in einer Ebene zwischen dem Ende der Ringspule (4), welches dem Beschichtungsmaterial am nächsten ist, und einem Ende der Ringspule (4), welches dem Beschichtungsmaterial am entferntesten ist, befinden.

4. Arc-Verdampfungsquelle gemäss Anspruch 2 oder 3, **dadurch gekennzeichnet, dass** die Magnetanordnung derart konfiguriert ist, dass bei der zweiten Einstellung der Magnetfeldanordnung, die Zentralpermanentmagneten (5a) und die Rand-Permanentmagneten (5) einer Position einnehmen können, bei der die Pole der Permanentmagneten (5, 5a) sich in einer Ebene befinden, die weiter beanstandet von der Targetoberfläche ist als das Ende der Ringspule (4), welches dem Beschichtungsmaterial am entferntesten ist.

5. Arc-Verdampfungsquelle gemäss einem der vorangehenden Ansprüche 1 bis 4, **dadurch gekennzeichnet, dass** die Ringspule (4) fix angeordnet ist.

6. Arc-Verdampfungsquelle gemäss einem der vorangehenden Ansprüche 1 bis 5, **dadurch gekennzeichnet, dass** die Magnetanordnung derart konfiguriert ist, das die Zentralpermanentmagneten (5a) unabhängig von den Rand-Permanentmagneten (5), im Wesentlichen senkrecht zur Oberflache des Targets vom Target weg verschiebbar sind.

7. Arc-Verdampfungsquelle gemäss Anspruch 6, **dadurch gekennzeichnet, dass** die Magnetanordnung derart konfiguriert ist, dass bei einer dritten Einstellung der Magnetfeldanordnung, die Zentralpermanentmagneten (5a) eine Position einnehmen können, bei der die Zentralpermanentmagneten (5a) in einer Ebene sind, welche zurückgezogen, weiter beanstandet von der Targetoberfläche als die Rand-Permanentmagneten (5) ist.

8. Arc-Verdampfungsanlage mit einer Arc-Verdampfungsquelle nach einem der Anspruche 1 bis 7.

9. Methode zur Beschichtung von Substraten in einer Vakuumbeschichtungsanlage nach Anspruch 8, **dadurch gekennzeichnet, dass** zur Abscheidung der Beschichtung ein Magnetfeld durch die Magnetkonfiguration generierten wird und die Stärke des Magnetfeldes durch die Position der Permanentmagneten (5, 5a) eingestellt wird.

10. Methode nach Anspruch 9, **dadurch gekennzeichnet, dass** die Position der Permanentmagneten (5, 5a) so ausgewählt wird, dass bei dieser Position die Pole der Permanentmagneten (5, 5a) dem Beschichtungsmaterial so nah sind, dass sie , im Wesentlichen in der gleichen Ebene des Endes der Ringspule (4), welches dem Beschichtungsmaterial am nächsten ist, sind, und dadurch ein starkes Magnetfeld von ca. 60-100 Gauss generiert wird.

11. Methode nach Anspruch 9, **dadurch gekennzeichnet, dass** die Position der Permanentmagneten (5, 5a) so ausgewählt wird, dass die Permanentmagneten (5, 5a) zurückgezogen, so weg beanstandet von der Targetoberfläche sind, dass dadurch ein Magnetfeld von ca. 10-40 Gauss generiert wird.

12. Methode nach Anspruch 9, **dadurch gekennzeichnet, dass** die Position der Permanentmagneten (5, 5a) so ausgewählt wird, dass die Permanentmagneten (5, 5a) zurückgezogen, so weg beanstandet von der Targetoberfläche sind, dass dadurch ein Magnetfeld mit einem so kleinen Magnetfeldanteil der Permanentmagneten (5, 5a) generiert wird, dass die Stärke des Magnetfelds durch die Stromstärke der Ringspule definiert wird, wenn der Ringspulenstrom eingeschaltet wird.

## Claims

1. ARC vaporization source with a magnetic field arrangement provided on a target (2) comprising coating material for generating magnetic fields on and above the target surface, wherein the magnetic field arrangement comprises central permanent magnets (5a), marginal permanent magnets (5) and at least one ring coil (4) placed behind the target, whose inner diameter bounded by the windings is preferably smaller than or equal to, and in any case not considerably larger than the diameter of the target, **characterized in that** the marginal permanent magnets (5) and the central permanent magnets (5a) can be displaced away from the target (2) essentially perpendicularly to the surface of the target (2) and the projection of the marginal permanent magnets (5) onto the target surface is further away from the middle of the target surface by comparison to the projection of the ring coil (4) onto the target surface, wherein the marginal permanent magnets (5) and the central permanent magnets can be displaced independently from the ring coil (4), and wherein the magnet arrangement is configured in such a manner that at a first setting of the magnetic field arrangement the central permanent magnets (5a) and the marginal permanent magnets (5) can take a first position in which the poles of the permanent magnets (5, 5a) are closest to the coating material, and wherein the poles of the permanent magnets (5, 5a) lie essentially in one plane in which there is also one end of the ring coil (4) that is closest to the coating material.

2. ARC vaporization source according to claim 1, **characterized in that** the magnetic arrangement is configured in such a manner that at a second setting of the magnetic field arrangement the central permanent magnets (5a) and the marginal permanent magnets (5) can take a second position in which the permanent magnets (5, 5a) are pulled back, further away from the target surface and in which the end of the ring coil (4) that is closest to the coating material lies in one plane closer to the coating material than the poles of the permanent magnets (5, 5a).

3. ARC vaporization source according to claim 2, **characterized in that** the magnetic arrangement is configured in such a manner that at the second setting of the magnetic field arrangement the central permanent magnets (5a) and the marginal permanent magnets (5) can take a position in which the poles of the permanent magnets (5, 5a) lie in one plane between the end of the ring coil (4) which is closest to the coating material and an end of the ring coil (4) which is furthest away from the coating material.

4. ARC vaporization source according to claims 2 or 3 **characterized in that** the magnetic arrangement is configured in such a manner that at the second setting of the magnetic field arrangement the central permanent magnets (5a) and the marginal permanent magnets (5) can take a position in which the poles of the permanent magnets (5, 5a) lie in a plane which is further away from the target surface than the end of the ring coil (4) which is furthest away from the coating material.

5. ARC vaporization source according to one of the preceding claims 1 to 4, **characterized in that** the ring coil (4) is arranged fixedly.

6. ARC vaporization source according to one of the preceding claims 1 to 5, **characterized in that** the magnetic arrangement is configured in such a manner that the central permanent magnets (5a) can be displaced away from the target independently of the marginal permanent magnets (5) essentially perpendicularly to the surface of the target.

7. ARC vaporization source according to claim 6, **characterized in that** the magnetic arrangement is configured in such a manner that at a third setting of the magnetic field arrangement the central permanent magnets (5a) can take a position in which the central permanent magnets (5a) are in a plane which is pulled back, further away from the target surface than the marginal permanent magnets (5).

8. ARC vaporization installation with an ARC vaporization source according to one of the claims 1 to 7.

9. Method for coating substrates in a vacuum coating facility according to claim 8, **characterized in that** a magnetic field is generated by the magnetic configuration for the deposition of the coating and the strength of the magnetic field is adjusted by the position of the permanent magnets (5, 5a).

10. Method according to claim 9, **characterized in that** the position of the permanent magnets (5, 5a) is chosen such that in this position the poles of the permanent magnets (5, 5a) are close to the coating material such that they are essentially in the same plane of the end of the ring coil (4) which is closest to the coating material and thus a strong magnetic field of about 60-100 gauss is generated.

11. Method according to claim 9, **characterized in that** the position of the permanent magnets (5, 5a) is chosen such that the permanent magnets (5, 5a) are pulled back, spaced away from the target surface in such a manner that a magnetic field of about 10-40 gauss is generated.

12. Method according to claim 9, **characterized in that** the position of the permanent magnets (5, 5a) is chosen such that the permanent magnets (5, 5a) are pulled back, spaced away from the target surface in such a manner that a magnetic field with such a small magnetic field portion of permanent magnets (5, 5a) is generated that the strength of the magnetic field is defined by the current strength of the ring coil, if the ring coil current is switched on.

## Revendications

1. Source d'évaporation d'ARC ayant une configuration du champ magnétique prévue à une cible (2) d'un matériau de revêtement pour produire des champs magnétiques à et au-dessus de la surface de la cible, la configuration du champ magnétique comprenant des aimants permanents centraux (5a) et des aimants permanents marginaux (5) et du moins une bobine annulaire (4) disposée derrière la cible, le diamètre intérieur de la bobine annulaire limité par les enroulements étant de préférence plus petit ou égal, en tout cas pas essentiellement plus grand que le diamètre de la cible, **caractérisé par le fait que** les aimants permanents marginaux (5) et les aimants permanents centraux (5a) peuvent être déplacés essentiellement perpendiculairement à la surface de la cible (2) de façon à s'éloigner de la cible (2) et la projection des aimants permanents marginaux (5) sur la surface de la cible, comparé à la projection de la bobine annulaire (4) sur la surface de la cible est plus éloignée du centre de la surface de la cible, les aimants permanents marginaux (5) et les aimants permanents centraux pouvant être déplacés indépendemment de la bobine annulaire (4) et la configuration magnétique étant configurée de telle manière que lors d'un premier réglage de la configuration du champ magnétique les aimants magnétiques centraux (5a) et les aimants permanents marginaux (5) puissent prendre une première position où les pôles des aimants permanents (5, 5a) sont les plus proches du matériau de revêtement, et les pôles des aimants permanents (5, 5a) se trouvent essentiellement dans un plan où se trouve également une fin de la bobine annulaire (4) qui est la plus proche du matériau de revêtement.

2. Source d'évaporation d'ARC selon la revendication 1, **caractérisée par le fait que** la configuration magnétique est configurée de telle manière que lors d'un deuxième réglage de la configuration du champ magnétique les aimants permanents centraux (5a) et les aimants permanents marginaux (5) puissent prendre une deuxième position où les aimants permanents (5, 5a) sont retirés, plus éloignés de la surface de la cible et où la fin de la bobine annulaire (4) qui est la plus proche du matériau de revêtement est dans un plan plus proche du matériau de revêtement que les pôles des aimants permanents (5, 5a).

3. Source d'évaporation d'ARC selon la revendication 2, **caractérisée par le fait que** la configuration magnétique est configurée de telle manière que lors du deuxième réglage de la configuration du champ magnétique les aimants permanents centraux (5a) et les aimants permanents marginaux (5) puissent prendre une position où les pôles des aimants permanents (5, 5a) se trouvent dans un plan entre la fin de la bobine annulaire (4) qui est la plus proche du matériau de revêtement et une fin de la bobine annulaire (4) qui est la plus éloignée du matériau de revêtement.

4. Source d'évaporation d'ARC selon la revendication 2 ou 3, **caractérisée par le fait que** la configuration magnétique est configurée de telle manière que lors du deuxième réglage de la configuration du champ magnétique les aimants permanents centraux (5a) et les aimants permanents marginaux (5) puissent prendre une position où les pôles des aimants permanents (5, 5a) se trouvent dans un plan qui est plus éloigné de la surface de la cible que la fin de la bobine annulaire (4) qui est la plus éloignée du matériau de revêtement.

5. Source d'évaporation d'ARC selon une des revendications précédentes 1 à 4, **caractérisée par le fait que** la bobine annulaire (4) est disposée de manière fixe.

6. Source d'évaporation d'ARC selon une des revendications précédentes 1 à 5, **caractérisée par le fait que** la configuration magnétique est configurée de telle manière que les aimants permanents centraux (5a) puissent être déplacés indépendemment des aimants permanents marginaux (5) essentiellement perpendiculairement à la surface de la cible de façon à s'éloigner de la cible.

7. Source d'évaporation d'ARC selon la revendication 6, **caractérisée par le fait que** la configuration magnétique est configurée de telle manière que lors d'un troisième réglage de la configuration du champ magnétique les aimants permanents centraux (5a) puissent prendre une position où les aimants permanents centraux (5a) sont dans un plan qui est retiré, plus éloigné de la surface de la cible que les aimants permanents marginaux (5).

8. Installation d'évaporation d'ARC ayant une source d'évaporation d'ARC selon une des revendications 1 à 7.

9. Procédé de revêtement de substrats dans une installation de revêtement sous vide selon la revendication 8, **caractérisé par le fait que** pour le dépôt du revêtement un champ magnétique est produit par la configuration magnétique et l'intensité du champ magnétique est réglée par la position des aimants permanents (5, 5a).

10. Procédé selon la revendication 9, **caractérisé par le fait que** la position des aimants permanents (5, 5a) est choisie de telle manière que dans cette position les pôles des aimants permanents (5, 5a) soient tellement proches du matériau de revêtement qu'ils sont essentiellement dans le même plan de la fin de la bobine annulaire (4) qui est la plus proche du matériau de revêtement et ainsi un champ magnétique fort d'environ 60 - 100 gauss est généré.

11. Procédé selon la la revendication 9, **caractérisé par le fait que** la position des aimants permanents (5, 5a) est choisie de telle manière que les aimants permanents (5, 5a) soient retirés, éloignés de la surface de la cible de manière qu'un champ magnétique d'environ 10-40 gauss soit généré.

12. Procédé selon la revendication 9, **caractérisé par le fait que** la position des aimants permanents (5, 5a) est choisie de telle manière que les aimants permanents (5, 5a) soient retirés, éloignés de la surface de la cible de manière qu'un champ magnétique soit généré qui a une tellement petite proportion d'aimants permanents (5, 5a) que l'intensité du champ magnétique est déterminée par le courant de la bobine annulaire si le courant de la bobine annulaire est allumé.
